# FASCICULE DE BREVET EUROPEEN

(11) **EP 3 410 199 B1**
(45) Date de publication et mention de la délivrance du brevet: **29.01.2020**
(21) Numéro de dépôt: 18172671.2
(22) Date de dépôt: 16.05.2018
(51) Int. Cl.: G03B 17/55, B60S 1/02, B60R 16/03, G03B 17/12

(54) **DISPOSITIF OPTIQUE POUR VEHICULE COMPRENANT UN ELEMENT DE CHAUFFAGE**
OPTISCHE VORRICHTUNG FÜR EIN FAHRZEUG MIT EINEM HEIZELEMENT
OPTICAL DEVICE FOR VEHICLE COMPRISING A HEATING ELEMENT

(30) Priorité: 01.06.2017 FR 1754881
(43) Date de publication de la demande: 05.12.2018
(73) Titulaire: Aptiv Technologies Limited, St. Michael (BB)
(72) Inventeur: ZUROWSKI, Miroslaw J., 30-348 Krakow (PL); POREDA, Witold, 12-221 RUCIANE NIDA (PL); RAFALOWSKI, Arkadiusz, 32-064 BRZEZINKA (PL)
(74) Mandataire: Vigand, Philippe

(56) Documents cités:
- EP-A1- 3 163 864
- WO-A1-2015/161097
- WO-A2-2004/047421
- CN-A- 106 195 665
- KR-A- 20160 042 783

## Description

### DOMAINE TECHNIQUE

La présente invention concerne un dispositif optique pour véhicule et plus particulièrement un dispositif optique comprenant un élément de chauffage

### ARRIERE-PLAN TECHNOLOGIQUE DE L'INVENTION

Les organes électroniques pour véhicule automobile et agencés à l'extérieur des véhicules doivent subir les contraintes environnementales telles le froid et la glace. Afin de ne pas subir les effets persistant de ces contraintes, ces organes électroniques sont généralement équipés dispositifs électriques permettant de se débarrasser des effets de ces contraintes. On peut par exemple trouver des organes électroniques munis de dispositifs électriques tels que par exemple des éléments chauffant pour combattre le gel.

Le pilotage de ces dispositifs électriques est généralement réalisé par le biais de faisceaux électriques et de connecteurs reliant une carte de contrôle électronique et les dispositifs électriques.

Il est connu du document WO2004/047421, un système d'imagerie pour un véhicule, qui comprend un module caméra pouvant être positionné au niveau du véhicule, et une commande.

Il est également connu du document WO2015/161097, un ensemble intégré de capteurs d'image multiples et de buse de lavage de lentille.

Les solutions actuelles de raccordement électrique de ces dispositifs électriques sont encombrantes, couteuses et lourdes.

Il est donc important de proposer une solution nouvelle résolvant ces problèmes.

### RESUME DE L'INVENTION

Selon l'invention, un dispositif optique selon la rev. indépendante 1, comprend une carte à circuit imprimé comprenant un circuit électronique de capture d'images, un support de lentille comprenant au moins une lentille optique, le support de lentille étant monté sur la carte à circuit imprimé de sorte à aligner, selon l'axe optique du dispositif, le circuit électronique de capture d'images et la lentille optique; un élément de chauffage agencé sur le support de lentille ; l'élément de chauffage étant relié électriquement à la carte à circuit imprimé par au moins une trace électriquement conductrice agencée sur le support de lentille.

La trace électriquement conductrice peut comprendre une zone de contact électrique qui est en contact électrique direct avec un plot de raccordement électrique de la carte à circuit imprimé.

La carte à circuit imprimé peut comporter une partie flexible sur laquelle est agencé le plot de raccordement électrique en contact avec la zone de contact électrique de la trace électriquement conductrice.

Le support de lentille peut être réalisé d'une seule pièce avec un boîtier supérieur monté dans un boîtier inférieur, la zone de contact électrique étant agencée sur la face externe de la paroi cylindrique du boîtier supérieur, et en ce que la partie flexible est pincée entre la paroi cylindrique du boîtier supérieur et la paroi cylindrique du boîtier inférieur.

La trace conductrice peut se prolonger jusqu'à l'extrémité libre externe u support de lentille pour former l'élément de chauffage, par exemple en formant un anneau.

Le support de lentille peut comprendre une première couche isolante sur laquelle est agencée la trace électriquement conductrice.

Le support de lentille peut comprendre une seconde couche isolante recouvrant la trace électriquement conductrice à l'exception de sa zone de contact électrique.

Selon l'invention, une méthode de fabrication selon la rev. indépendante 6, d'un dispositif optique tel que décrit ci-dessus, comporte les étapes suivantes :
fourniture d'un support de lentille monté sur une carte à circuit imprimé comprenant une partie rigide et une partie flexible comprenant un plot de raccordement électrique;
agencement d'un élément de chauffage sur le support de lentille;
application d'une première couche isolante sur le support de lentille;
réalisation d'une trace électriquement conductrice sur la première couche isolante s'étendant depuis l'élément de chauffage jusqu'à une extrémité formant une zone de contact électrique de la trace électriquement conductrice;
application d'une seconde couche isolante recouvrant entièrement la trace électriquement conductrice à l'exception de la zone de contact électrique;
insertion du support de lentille dans un boîtier inférieur de sorte à pincer le plot de raccordement électrique de la partie flexible entre une paroi du boîtier inférieur et la zone de contact électrique agencée sur le support de lentille.

D'autres buts et avantages de la présente invention apparaîtront au vu de la description qui suit.

### BREVE DESCRIPTION DES DESSINS

D'autres caractéristiques, buts et avantages de l'invention apparaîtront à la lecture de la description détaillée qui va suivre, et en regard des dessins annexés, donnés à titre d'exemple non limitatif et sur lesquels:
- La figure 1 est une vue schématique en perspective éclatée du dispositif optique selon l'invention.
- La figure 2 est une vue schématique en perspective en coupe transversale du dispositif optique de la figure 1 assemblé.
- La figure 3 est une vue schématique en perspective en coupe transversale du dispositif optique de la figure 1 assemblé selon laquelle le corps du connecteur est représenté sans l'ensemble de terminaux électriques.
- La figure 4 est une vue schématique en perspective du boîtier inférieur et de son fond de boîtier du dispositif optique de la figure 1, le fond de boîtier étant représenté avec les contacts électriques de l'ensemble de terminaux électriques.
- La figure 5 est une vue schématique en perspective en coupe transversale du boîtier supérieur assemblé avec la première carte à circuit imprimé, la coupe transversale permettant de visualiser le conduit du boîtier supérieur.
- La figure 6 est une vue schématique en perspective en coupe transversale du boîtier supérieur de la figure 5 assemblé avec le boîtier inférieur du dispositif optique de l'invention.
- La figure 7 est une vue schématique en perspective de la face supérieure de la première carte à circuit imprimé du dispositif optique de la figure 1.
- La figure 8 est une vue schématique en perspective de la face inférieure de la première carte à circuit imprimé du dispositif optique de la figure 1.
- La figure 9 est une vue schématique en perspective en coupe transversale d'une étape intermédiaire d'insertion du boîtier supérieur avec le boîtier inférieur du dispositif optique de la figure 1.
- La figure 10 est une vue schématique partielle en perspective en coupe transversale du dispositif optique de la figure 1 assemblé illustrant la liaison électrique de la première carte à circuit imprimé avec le boîtier supérieur et avec le boîtier inférieur.
- La figure 11 est une vue schématique agrandie de la figure 10 au niveau de la liaison électrique de la première carte à circuit imprimé avec le boîtier supérieur et avec le boîtier inférieur.
- La figure 12 est une vue schématique en perspective du boîtier supérieur équipé de traces électriquement conductrices.
- La figure 13 est une vue schématique en perspective du boîtier supérieur équipé de traces électriquement conductrices et équipé de la première carte à circuit imprimé dont les parties flexibles sont représentées en contact avec les traces électriquement conductrices.
- La figure 14 est une représentation schématique de l'élément de chauffage et de son système d'alimentation électrique.
- Les figures 15, 16, 17 et 18 sont des vues schématiques en perspectives du boîtier supérieur selon quatre étapes de réalisation des traces conductrices et des couches de protection du dispositif optique selon l'invention.
- La figure 19 est une vue schématique en perspective partiellement éclatée du dispositif optique de l'invention illustrant une méthode d'assemblage du dispositif optique.
- La figure 20 est une vue schématique en perspective du dispositif optique assemblé.

### DESCRIPTION DES MODES DE REALISATION PREFERES

Afin de faciliter la description, et de façon non limitative, un repère orthogonal comprenant un axe longitudinal L, un axe transversal T et un axe vertical V est défini. Des orientations « bas », « haut », « dessus », « dessous », « inférieure » et « supérieure » sont définies selon la direction verticale. Des orientations « gauche », « droite » et « latérale » sont définies selon la direction transversale. Des orientations « avant » et « arrière » sont également définies selon la direction longitudinale.

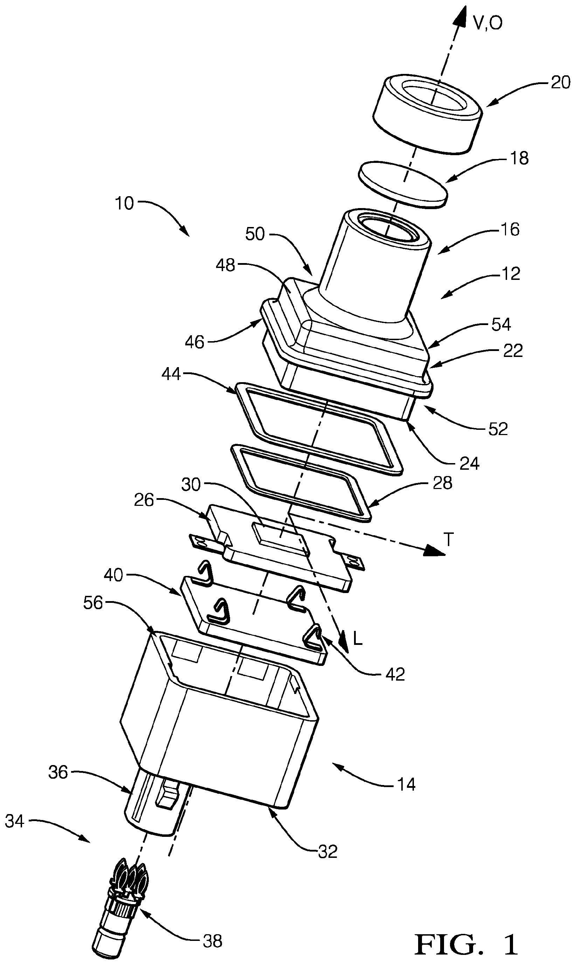

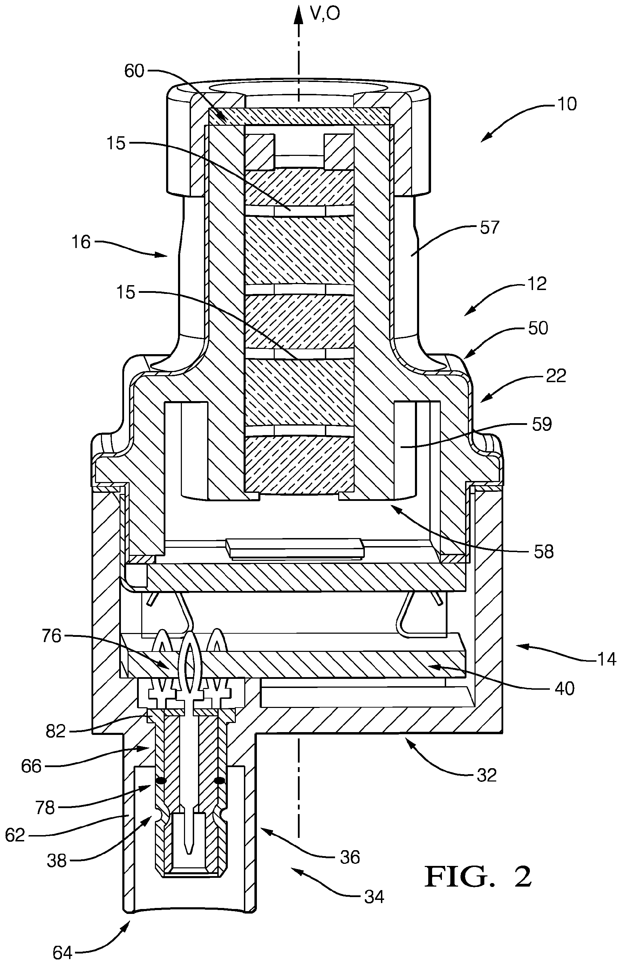

Selon la figure 1 et la figure 2, un dispositif optique 10, plus particulièrement une caméra pour véhicule est représentée. Ce type de caméra est prévu pour être monté à l'extérieur du véhicule et donc subir les conditions extérieures au véhicule tel que le climat.

Selon la figure 1, le dispositif optique 10 comprend un boîtier supérieur 12 et un boîtier inférieur 14.

Le boîtier supérieur 12 comporte un support de lentilles 16 équipé de lentilles optiques 15 et surmonté d'une glace de protection 18 maintenue sur le support de lentilles 16 par un capot de maintien 20. Le boîtier supérieur 12 comporte également une base 22 cylindrique ouverte à son extrémité basse 24 et une paroi d'extrémité supérieure 50; une première carte à circuit imprimé 26 étant prévue pour être fixée sur l'extrémité basse 24, par l'intermédiaire d'un premier joint adhésif 28, de sorte à fermer hermétiquement le boîtier supérieur 12.

La première carte à circuit imprimé 26 comprend un circuit électronique de capture d'images 30 aligné avec les lentilles selon l'axe optique O du dispositif optique 10.

Le boîtier inférieur 14 est de forme cylindrique creux à base rectangulaire. Le boîtier inférieur 14 comporte un fond de boîtier 32 comprenant un connecteur 34. Le connecteur 34 comprend un corps de connecteur 36 venu de matière avec le boîtier inférieur 14 ainsi qu'un ensemble de terminaux électriques 38 prévu pour être inséré dans le corps du connecteur 36 et prévu pour être en contact électrique avec une seconde carte à circuit imprimé 40.

La seconde carte à circuit imprimé 40 comporte des moyens de connexions électriques 42 avec la première carte à circuit imprimé 26, plus particulièrement, les moyens de connexions électriques 42 sont réalisés par des languettes élastiques fixées sur la seconde carte à circuit imprimé 40 et en contact par compression avec la première carte à circuit imprimé. 26

Le boîtier supérieur 12 est fixé au boitier inférieur 14 au moyen d'un second joint adhésif 44. Plus particulièrement, la base 22 du boîtier supérieur 12 comprend un rebord 46 externe cylindrique agencé sur la surface extérieure de la paroi cylindrique 48 de la base 22 du boîtier supérieur 12. Le rebord 46 est agencé entre la paroi d'extrémité supérieure 50 et l'extrémité basse 24 de la base 22 de sorte à définir une portion haute 54 et une portion basse 52 de la base 22 du boîtier supérieur 12. La portion basse 52 de la base 22 vient s'insérer dans le boîtier inférieur 14 jusqu'à ce que le rebord 46 de la base 22 du boîtier supérieur 12 vienne en butée contre le second joint adhésif 44 agencé sur la surface supérieure de l'extrémité haute 56 du boîtier inférieur 14. La surface supérieure de l'extrémité haute 56 du boîtier inférieur 14 forme ainsi une surface d'appui.

De façon alternative, la surface d'appui du boîtier inférieur peut être agencée ailleurs que sur l'extrémité haute 56 du boîtier inférieur 14. A titre d'exemple, la surface d'appui peut être formée par un rebord interne à la surface interne 118 de la paroi cylindrique 116 du boîtier inférieur 14.

De façon optionnelle, le second joint adhésif 44 peut être réalisé par un dépôt de colle sur la surface supérieure de l'extrémité haute 56 du boîtier inférieur 14, ou encore sur le rebord 46 de la base 22 du boîtier supérieur 12.

Plus en détail et selon la figure 2, la paroi d'extrémité supérieure 50 de la base 22 du boîtier supérieur 12 est traversée par le support de lentilles 16 tubulaire. Le support de lentilles 16 s'étend selon l'axe optique O du dispositif optique 10 depuis sa première extrémité agencée à l'intérieur de la base 22 jusqu'à sa seconde extrémité agencée en dehors de la paroi d'extrémité supérieure 50 de la base 22. La seconde extrémité est une extrémité libre externe 60 du support de lentilles 16. La partie du support de lentilles 16 agencée à l'intérieur de la base 22 définie un tronçon inférieur 59 du support de lentille 16, la partie du support de lentilles 16 agencée en dehors de la base 22 définie un tronçon supérieur 57 du support de lentilles 16. Le support de lentilles 16 représenté comprend quatre lentilles globalement régulièrement espacées. Cet agencement permet une structure multi lentilles tout en minimisant la longueur, selon l'axe optique O, du dispositif optique 10.

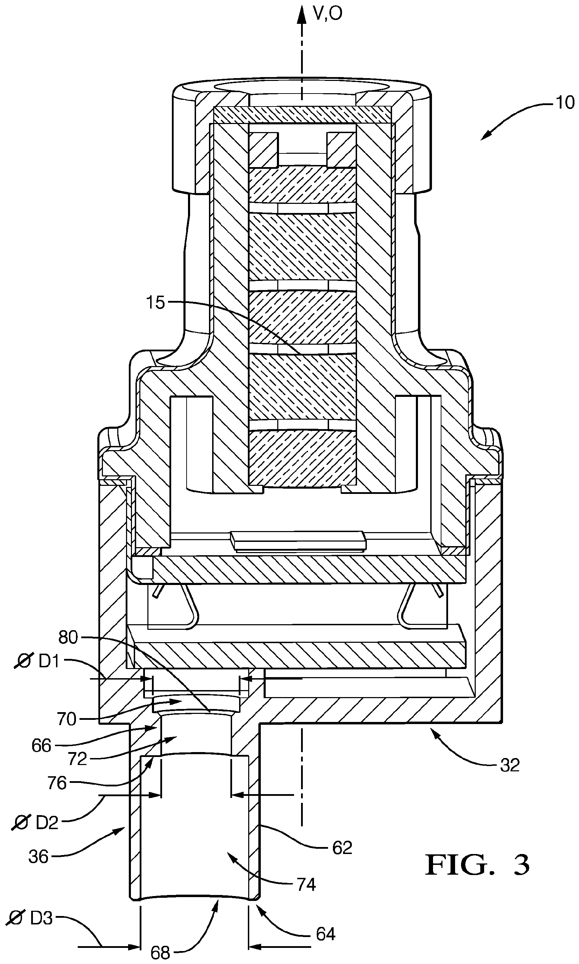

Selon la figure 2 et la figure 3, le corps du connecteur 36 comprend une paroi cylindrique 62 de base circulaire s'étendant verticalement depuis la face extérieure du fond de boitier 32 jusqu'à son extrémité libre 64 et une portion 66 creusée dans l'épaisseur du fond de boîtier 32. Le corps du connecteur 36 comprend une cavité cylindrique 68 de base circulaire comprenant trois tronçons, de diamètres différents, en continuités les uns avec les autres. La cavité à trois tronçons permet d'agencer fixement l'ensemble de terminaux électriques.

Le premier tronçon 70 est creusé globalement depuis la surface interne de la paroi du fond de boîtier 32 jusqu'à mi épaisseur de la paroi du fond de boîtier 32. Le premier tronçon 70 est un tronçon cylindrique de base circulaire comprenant un premier diamètre D1. Le second tronçon 72, en continuité avec le premier tronçon 70, forme une cavité de second diamètre D2 légèrement inférieur au premier diamètre D1. Le second tronçon 72 s'étend depuis globalement la mi épaisseur de la paroi du fond de boîtier 32 jusqu'à son extrémité 76 externe au fond de boîtier 32. Le troisième tronçon 74, en continuité avec le second tronçon 72, comprend un troisième diamètre D3 aussi bien supérieur au second diamètre D2 qu'au premier diamètre D1.

L'ensemble de terminaux électriques 38 comprend une partie supérieure formée de contacts électriques 76 insérés dans la seconde carte à circuit imprimé 40; et une seconde partie cylindrique, formant la base 78 de l'ensemble de terminaux électriques 38. Plus précisément, les contacts électriques 76 sont insérés en force dans la seconde carte à circuit imprimé 40 permettant ainsi le contact électrique entre le connecteur 34 et la seconde carte à circuit imprimé 40.

La différence entre le premier diamètre D1 et le second diamètre D2 permet à la jonction entre le premier tronçon 70 et le second tronçon 72 de la cavité 68 du corps de connecteur 36 de former une marche ou rebord cylindrique 80 sur lequel un rebord supérieur 82 de la base 78 de l'ensemble de terminaux électriques 38 vient en appui. Selon le mode de réalisation représenté, le rebord supérieur 82 de la base 78 de l'ensemble de terminaux électriques 38 est agencé à l'extrémité supérieure de la base 78.

Le diamètre D2 du second tronçon 72 est également ajusté de sorte à ce que la partie de la base 78 de l'ensemble de terminaux électriques 38 en continuité avec le rebord supérieur 82 de la base 78 de l'ensemble de terminaux électriques 38 vient s'insérer en frottement contre la paroi interne du second tronçon 72 de sorte à ne pas pouvoir pivoter latéralement.

La base 78 de l'ensemble de terminaux électriques 38 comprend enfin une extrémité basse agencée dans la troisième cavité 74 de sorte à permettre l'accouplement électrique de l'ensemble de terminaux électriques 38 avec un terminal électrique complémentaire inséré dans la troisième cavité 74.

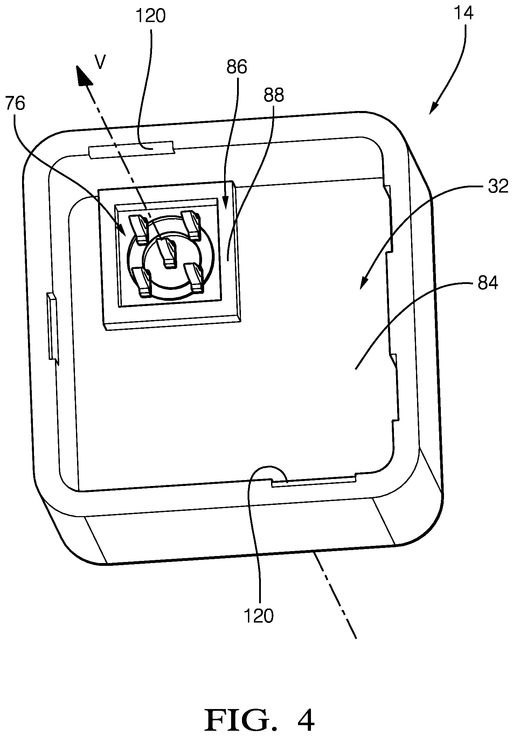

Selon la figure 4, la face interne 84 du fond de boîtier 32 comprend également une paroi cylindrique 86 de base rectangulaire interne au boîtier inférieur 14 et entourant les contacts électriques 76 de l'ensemble de terminaux électriques 38. La paroi cylindrique interne 86 au boîtier inférieur 14 est de hauteur, selon l'axe vertical V, inférieure aux contacts électriques 76 prévus pour être insérés dans la seconde carte à circuit imprimé 40, de sorte à permettre à la seconde carte à circuit imprimé 40 de venir en appui sur l'extrémité supérieure 88 de la paroi cylindrique interne 86 au boîtier inférieur 14.

Le maintien de la seconde carte à circuit imprimé 40 dans le fond du boîtier 32 est donc rendu possible par l'assemblage des contact électriques 76 dans la seconde carte à circuit imprimé 40, par l'agencement de la base 78 de l'ensemble de terminaux électriques 38 dans la cavité 68 du corps de connecteur 36 et par l'agencement de la seconde carte à circuit imprimé 40 contre l'extrémité supérieure 88 de la paroi cylindrique interne 86 au boîtier inférieur 14.

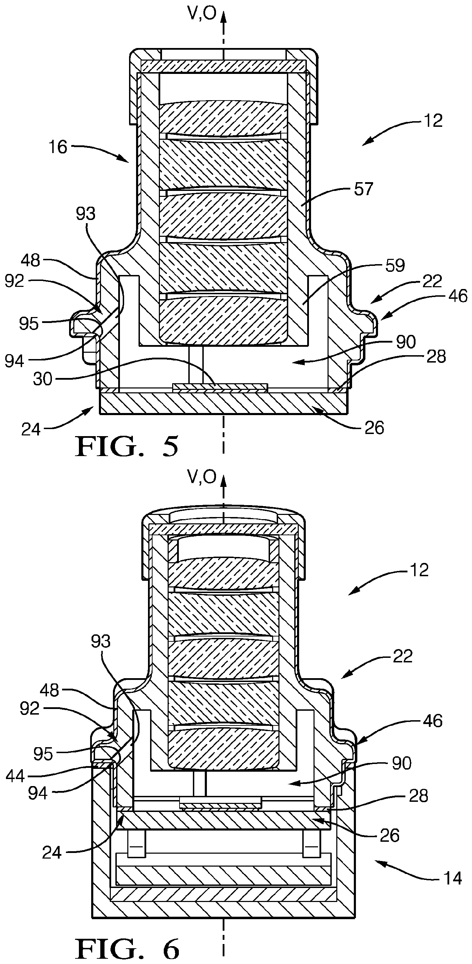

Selon la figure 5, le boîtier supérieur 12 est représenté fermé à l'extrémité basse 24 de la base 22 par la première carte à circuit imprimé 26 par l'intermédiaire du premier joint adhésif 28, formant ainsi une cavité 90 interne au boîtier supérieur 12. Plus précisément, la cavité interne 90 à la base 22 du boîtier supérieur 12 est l'espace libre délimité par la paroi cylindrique 48 de la base 22 et la première carte à circuit imprimé 26, tandis qu'un espace interne à la base cylindrique 22 est occupé par le tronçon inférieur 59 du support de lentilles 16 tubulaire agencée à l'intérieur de la base 22.

Un conduit 92 est agencé débouchant d'une part sur la face interne de la paroi cylindrique 48 de la base 22, par un orifice interne 93, et d'autre part à la jonction 94 entre la face externe de la paroi cylindrique 48 de la base 22 et la surface inférieure du rebord 46 de la base 22, par un orifice externe 95, de sorte permettre l'évacuation vers l'extérieur du boîtier supérieur 12 l'air comprimée dans la cavité 90 lors de l'assemblage du boîtier supérieur 12 avec la première carte à circuit imprimé 26.

En effet, lors du processus d'assemblage de la première carte à circuit imprimé 26 avec l'extrémité basse 24 de la base 22 du boîtier supérieur 12, l'air est comprimée dans la cavité 90. Le volume d'air augmente notamment lorsque le premier joint adhésif 28 est chauffé pour assurer son adhésion entre la première carte à circuit imprimé 26 et la base 22 du boîtier supérieur 12. L'augmentation du volume d'air, ou également sa compression dans la cavité 90 peut entrainer un déplacement des lentilles du support de lentilles 16 et donc corrompre l'alignement initial des lentilles avec le circuit électronique de capture d'image 30.

Le conduit 92 permet donc d'éliminer le risque de mauvais alignement entre les lentilles et le circuit électronique de capture d'images 30.

De façon optionnelle, le premier joint adhésif 24 peut être réalisé par un dépôt de colle sur la face inférieure de l'extrémité basse 24 de la base 22 du boîtier supérieur 12 ou par un dépôt de colle sur le pourtour de la première carte à circuit imprimé 26.

Il est à noter que selon la figure 6, lors de l'assemblage du boîtier supérieur 12 avec le boîtier inférieur 14, l'orifice externe 95 du conduit 92, débouchant sur la jonction 94 entre la face externe de la paroi cylindrique 48 de la base 22 et la surface inférieure du rebord 46 de la base 22, est bouché par le second joint adhésif 44, rendant la cavité interne 90 du boîtier supérieur 12 hermétique.

Afin d'agencer aisément l'orifice externe 95 du conduit 92, le conduit 92 est creusé de manière oblique vers le bas par rapport à l'axe optique O depuis l'orifice interne 93 vers l'orifice externe 95.

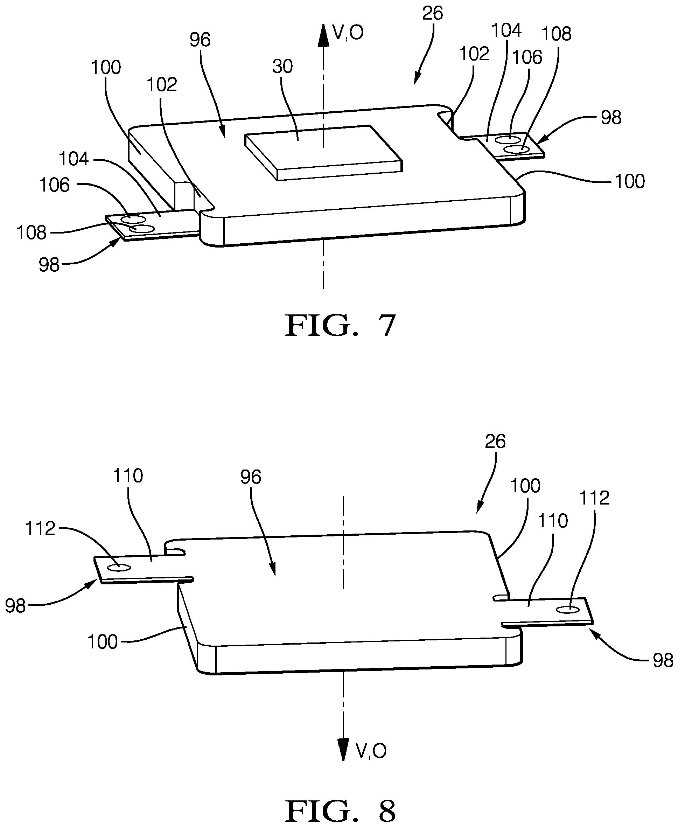

Selon la figure 7 et la figure 8, la première carte à circuit imprimé 26 est représentée avant l'assemblage complet du dispositif optique 10, c'est-à-dire avant l'assemblage du boîtier supérieur 12, dont l'extrémité basse 24 de la base 22 est fermée par la première carte à circuit imprimé 26, avec le boîtier inférieur 14. Le boîtier supérieur 12 et le boîtier inférieur 14 sont faits de métal conducteur. La première carte à circuit imprimé 26 comprend une partie rigide équipée du circuit électronique de capture d'images 30 et de deux parties flexibles 98 agencées de part et d'autre de la partie rigide 96. Ce type de circuit imprimé est communément appelé circuit imprimé flex-rigide. La partie flexible 98 comprend généralement un substrat amincie par rapport au substrat de la partie rigide 96. Généralement la partie flexible 98 comprend un substrat plastique sur lequel sont agencées des pistes conductrices. La partie rigide 96 de la première carte à circuit imprimé est globalement rectangulaire. Chaque partie flexible 98 est agencée sur un bord latéral 100 de la partie rigide 96. Plus particulièrement l'extrémité de jonction avec la partie rigide 96 de chaque partie flexible 98 est agencée dans une encoche 102 formée sur chaque bord latéral 100 de la partie rigide 96 de la première carte à circuit imprimé 26.

Chaque partie flexible 98 comprend sur sa face supérieure 104 un premier et un second plot de raccordement électrique 106, 108 bombés de forme globalement circulaire. Chaque partie flexible 98 comprend sur sa face inférieure 110 un troisième plot de raccordement électrique 112 bombé de forme globalement circulaire. Ces trois plots de raccordement électrique 106, 108, 112 permettent d'interfacer électriquement la première carte à circuit imprimé 26 à d'autres éléments électriques du dispositif.

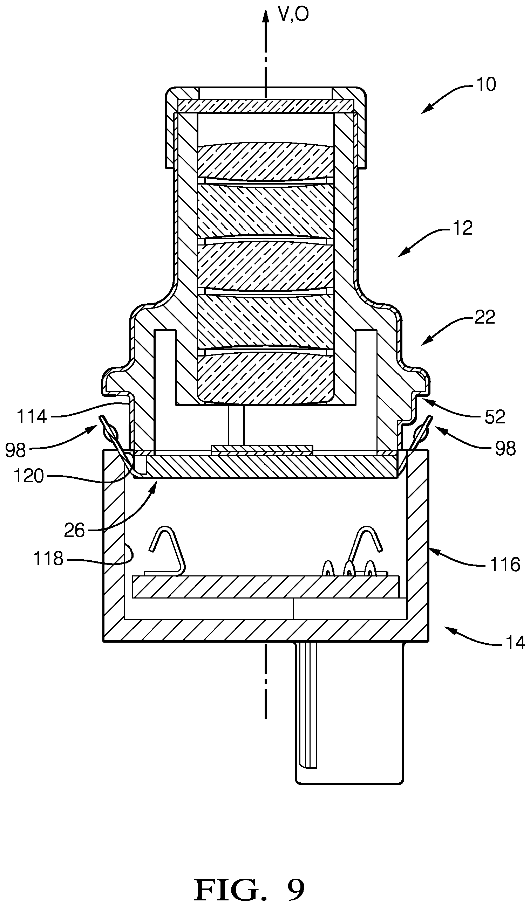

Selon le mode de réalisation représenté à la figure 9, lors de l'assemblage du boîtier supérieur 12 équipé de la première carte à circuit imprimé 26, avec le boîtier inférieur 14, c'est-à-dire lors de l'insertion de la portion basse 52 de la base 22 du boîtier supérieur 12 dans le boîtier inférieur 14, chaque partie flexible 98 de la première carte à circuit imprimé 26 vient se courber progressivement jusqu'à la verticale de sorte à être comprimée et pincée entre la surface extérieure 114 de la portion basse 52 de la base 22 du boîtier supérieur 12 et la surface interne 118 de la paroi cylindrique 116 du boîtier inférieur 14.

Afin d'éviter un endommagement de chaque partie flexible 98 de la première carte à circuit imprimé 26 lors de cette étape d'assemblage, l'extrémité haute 56 du boîtier inférieur 14 comprend deux arêtes 120 en pente inclinées formant chacune un chanfrein et orientées vers la surface interne 118 de la paroi cylindrique 116 du boîtier inférieur 14. Chaque arête 120 en pente inclinée est agencée dans l'alignement vertical de chaque partie flexible 98 de la première carte à circuit imprimé 26 de sorte, par exemple, à éviter un cisaillement de chaque partie flexible 98 lors de cette étape d'assemblage.

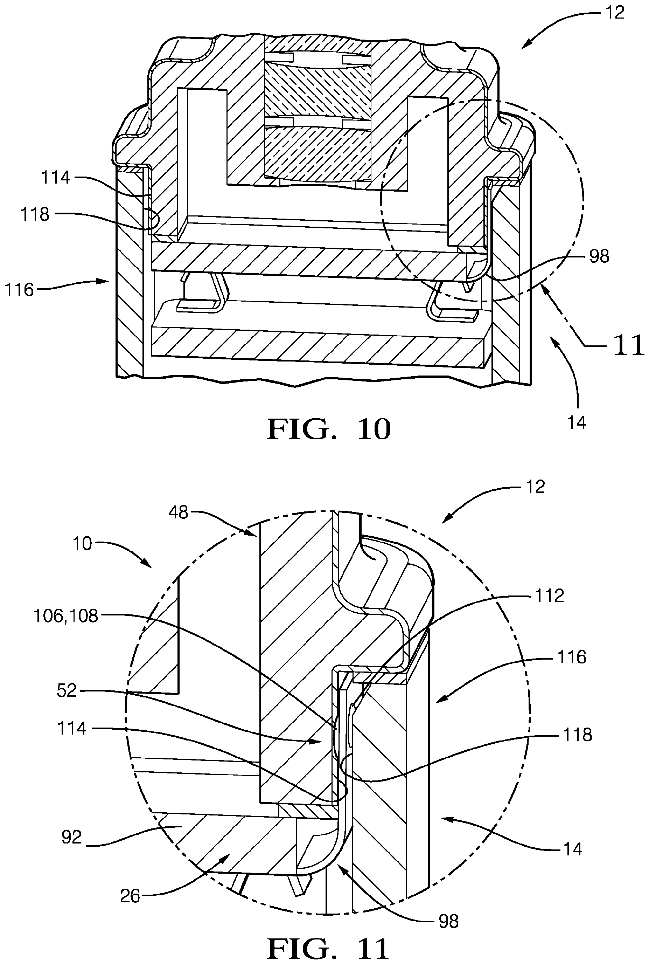

Selon la figure 10 et la figure 11, lorsque l'assemblage du boîtier supérieur 12 avec le boîtier inférieur 14 est terminé, chaque partie flexible 98 se trouve comprimée et pincée entre la surface extérieure 114 de la portion basse 52 de la base 22 du boîtier supérieur 12 et la surface interne 118 de la paroi cylindrique 116 du boîtier inférieur 14. Ainsi, le premièr et le second plot de raccordement électrique 106, 108 de chaque partie flexible 98 est en contact avec le boîtier supérieur 12; le troisième plot de raccordement électrique 112 de chaque partie flexible 98 est en contact avec le boîtier inférieur 14.

A titre d'exemple et de manière non limitative, la surface interne 118 de la paroi cylindrique 116 du boîtier inférieur 12 est en métal conducteur, de sorte qu'elle présente une surface de contact électrique plane contre laquelle chaque troisième plot de raccordement électrique 112 bombé assure une liaison électrique de masse électrique.

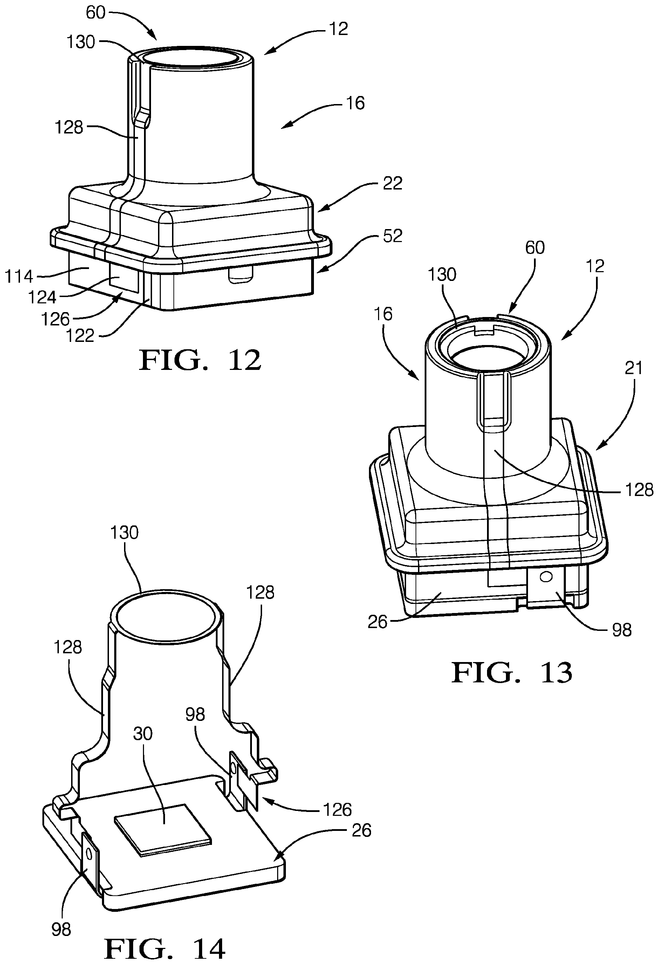

Selon le mode de réalisation de la figure 12 et de la figure 13, chaque premier plot de raccordement électrique 106 bombée de chaque partie flexible 98 de la première carte à circuit imprimé 26 est agencée contre une surface de contact électrique 122 venue de matière avec le boîtier supérieur 12 et agencée sur la surface extérieure 114 de la portion basse 52 de la base 22 du boîtier supérieur 12 de sorte à relier le boîtier supérieur 12 à la masse électrique du circuit électrique comprenant la première et la seconde carte à circuit imprimé 26, 40.

Chaque second plot de raccordement électrique 108 bombé de chaque partie flexible 98 est agencée contre une surface de contact électrique 124 isolée électriquement de la partie métallique du boîtier supérieur 12 et agencée sur la surface extérieure 114 de la portion basse 52 de la base 22 du boîtier supérieur 12.

Chaque surface de contact électrique 124 isolée électriquement de la partie métallique forme une zone de contact électrique 126 d'une trace électriquement conductrice 128 s'étendant depuis la zone de contact électrique 126 jusqu'à l'extrémité libre externe 60 du support de lentilles 16.

L'extrémité libre externe 60 du support de lentilles 16 comporte un élément de chauffage 130 alimenté électriquement par les traces électriquement conductrices 128 reliées électriquement à la première carte à circuit imprimé 26 par chaque second plot de raccordement électrique 108 bombé de chaque partie flexible 98 venant au contact des zones de contact électrique 126.

Selon le mode de réalisation représenté à figure 13 et modélisé à la figure 14, l'élément de chauffage 130 prévu pour dégivrer, si nécessaire, la glace de protection 18 du dispositif optique 10, est une trace conductrice annulaire agencée sur le dessus de l'extrémité libre externe 60 du support de lentilles 16 de sorte à être au contact avec la glace de protection 18 du dispositif optique 10. Les traces conductrices 128 peuvent par exemple, et de façon non limitative, être réalisées sur une couche isolante préalablement déposée sur la surface extérieure du boîtier supérieure 12. Les traces conductrices 128 peuvent être réalisées par pulvérisation de matière conductrice telle de la peinture comprenant des microparticules conductrices, ou encore par galvanoplastie.

Alternativement, l'élément de chauffage 130 peut être tout autre dispositif générant de la chaleur. A titre d'exemple, la trace annulaire agencée sur le dessus de la seconde extrémité du support de lentilles 16 peut être remplacée par un joint de colle conductrice, permettant non seulement le maintien de la glace de protection, mais aussi son échauffement par circulation de courant dans le joint de colle par le biais des traces électriquement conductrices.

Selon la figure 14, le principe de fonctionnement de l'élément de chauffage 130 consiste à faire circuler un courant électrique généré par la première carte à circuit imprimé 26 depuis le second plot de raccordement électrique 108 bombé d'une des parties flexibles 98 de la première carte circuit imprimé 26, au travers d'une des traces conductrices 128. Le courant généré continue son chemin électrique au travers l'élément de chauffage 130 formé par la trace électriquement conductrice de forme annulaire agencée sur le dessus de la paroi tubulaire du support de lentille 16. Le courant électrique fini son parcours vers la première carte à circuit imprimé au travers de l'autre trace conductrice 128 dont la zone de contact électrique 126 est au contact électrique avec le second plot de raccordement électrique 108 bombé de l'autre partie flexible 98.

L'invention ne se limite pas à l'utilisation des parties flexibles 98 de la première carte à circuit imprimé 26 comme dispositif de connexion électrique pour un dispositif optique 10. En effet, l'utilisation d'une carte à circuit imprimé de type flex-rigide, dont la partie flexible 98, équipée d'au moins un plot de raccordement électrique 108, vient s'insérer compressée entre deux parois afin d'assurer une liaison électrique depuis la carte à circuit imprimé flex-rigide vers l'une ou l'autre paroi ou vers les deux parois, peut convenir à tout autre organe électronique nécessitant une telle liaison.

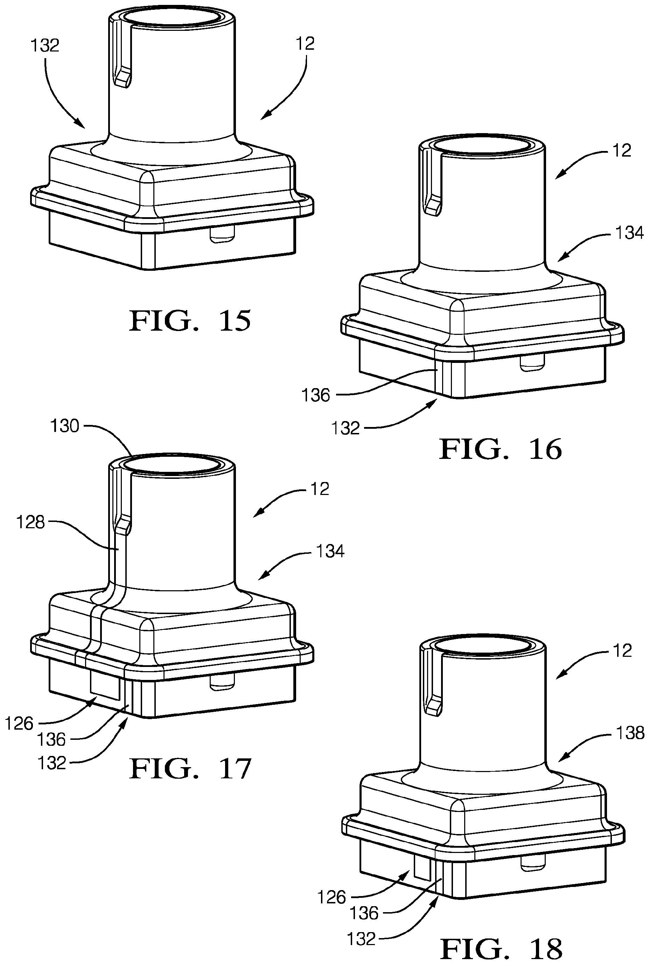

Selon la figure 15, la figure 16, la figure 17 et la figure 18, quatre étapes de réalisation de couches de protection du dispositif optique 10 sont représentés. Pour rappel, le dispositif optique 10 est prévu pour être monté à l'extérieur d'un véhicule automobile et donc de subir toutes les contraintes environnementales extérieures au véhicule.

Selon la figure 15, le boîtier supérieur 12 est un boîtier comprenant une surface extérieure métallique telle que par exemple un alliage d'aluminium.

Selon la figure 16, la surface extérieure métallique 132 du boîtier supérieur 12 est entièrement recouverte d'une première couche 134 électriquement isolante. Seules deux surfaces de contact électrique planes 136 (une seule visible) ou zones de contact métallique ne sont pas recouvertes de la première couche 134 électriquement isolante. Ces surfaces de contact électriques planes 136 sont venues de matière avec la surface métallique 132 du boîtier supérieur 12. Ces zones de contact sont prévues pour relier le boîtier supérieur 12 à la masse électrique du circuit électrique formé par la première et la seconde carte à circuit imprimé 26, 40 par le biais des deux parties flexibles 98 de la première carte à circuit imprimé 26.

Selon la figure 17, les deux traces (une seule visible) électriquement conductrices 128 reliées à l'élément de chauffage 130 et la trace électrique annulaire, faisant fonction d'élément de chauffage 130, agencée sur le dessus de l'extrémité libre externe 60 du support de lentilles 16, sont réalisées par-dessus la première couche 134 électriquement isolante.

Selon la figure 18, une seconde couche électriquement isolante 138, telle un vernis, recouvre entièrement les traces électriquement conductrices 128 et ainsi que la première couche électriquement 134 isolante, à l'exception des zones de contact électrique 126 des traces électriquement conductrices 128 et à l'exception des deux surfaces de contact électrique planes 136.

Une alternative consiste à ce que la première couche 134 et la seconde couche 138 électriquement isolante recouvrent entièrement la surface extérieure métallique 132 du boitier supérieur 12, les traces électriquement conductrices 128 étant toujours réalisées entre les deux couches 134, 138 électriquement isolantes, et qu'ensuite une opération de retrait local des couches électriquement isolantes 134, 138 réalisée au moyen d'un faisceau laser permette de faire apparaître les surfaces de contacts planes 136 du boîtier métallique 132 et les zones de contact électrique 126 des traces électriquement conductrices 128.

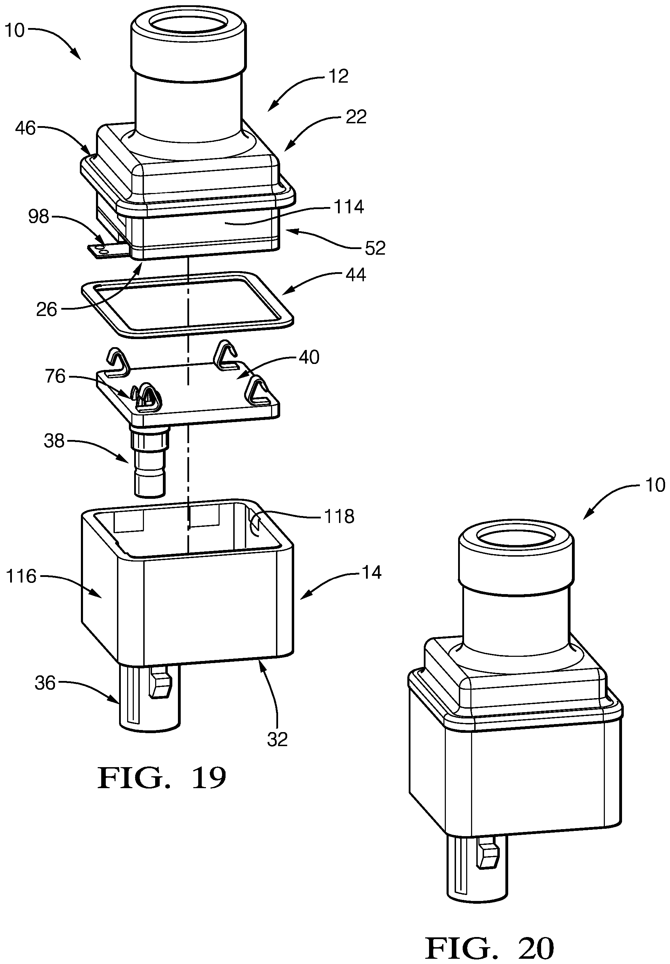

Selon la figure 19, une méthode d'assemblage du dispositif optique 10 décrit au travers de l'invention et représenté sur la figure 20 peut comprendre notamment les étapes suivantes.

Une étape consiste à insérer dans le fond de boitier 32 la seconde carte à circuit imprimé 40 préalablement équipée de l'ensemble de terminaux électriques 38 dont les contacts électriques 76 ont été insérés en force dans la seconde carte à circuit imprimé 40. Durant cette étape, le corps du connecteur 36 sert de guide d'insertion de la seconde carte à circuit imprimé 40 jusqu'à ce que la seconde carte à circuit imprimé 40 vienne en butée sur la paroi cylindrique interne 86 du boîtier inférieur 14.

Une autre étape consiste ensuite à disposer le second joint adhésif 44 sur la surface supérieure de l'extrémité haute 56 du boîtier inférieur 14.

Ensuite, une autre étape consiste à insérer la portion basse 52 de la base 22 du boîtier supérieur 12 dans le boîtier inférieur 14 jusqu'à ce que le rebord cylindrique 46 vienne en butée contre le second joint adhésif 44. Il est à noter que la première carte à circuit imprimé 26 a été préalablement assemblée sur l'extrémité basse du boîtier supérieur 12 de sorte que les parties flexibles 98 de la première carte à circuit imprimé 26 viendront se plier et s'agencer entre la surface extérieure 114 de la portion basse 52 de la base 22 du boîtier supérieur 12 et la surface interne 118 de la paroi cylindrique 116 du boîtier inférieur 14 lors de l'assemblage.

## Revendications

1. Dispositif optique (10) comprenant
une carte à circuit imprimé (26) comprenant un circuit électronique de capture d'images (30),
un support de lentille (16) comprenant au moins une lentille optique (15), le support de lentille (16) étant monté sur la carte à circuit imprimé (26) de sorte à aligner, selon l'axe optique (O) du dispositif (10), le circuit électronique de capture d'images (30) et la lentille optique (15);
un élément de chauffage (130) agencé sur le support de lentille (16) ; l'élément de chauffage (130) étant relié électriquement à la carte à circuit imprimé (26) par au moins une trace électriquement conductrice (128) agencée sur le support de lentille (16) et **caractérisé en ce que** le support de lentille (16) comprend une première couche isolante (134) sur laquelle est agencée la trace électriquement conductrice (128) et une seconde couche isolante (138) recouvrant la trace électriquement conductrice (128) à l'exception de sa zone de contact électrique (126).

2. Dispositif optique (10) selon la revendication 1 **caractérisé en ce que** la trace électriquement conductrice (128) comprend une zone de contact électrique (126) qui est en contact électrique direct avec un plot de raccordement électrique (108) de la carte à circuit imprimé (26).

3. Dispositif optique (10) selon la revendication 2 **caractérisé en ce que** la carte à circuit imprimé (26) comporte une partie flexible (98) sur laquelle est agencé le plot de raccordement électrique (108) en contact avec la zone de contact électrique (126) de la trace électriquement conductrice (128).

4. Dispositif optique (10) selon la revendication 3 **caractérisé en ce que** le support de lentille (16) est réalisé d'une seule pièce avec un boîtier supérieur (12) monté dans un boîtier inférieur (14), la zone de contact électrique (126) étant agencée sur la face externe (114) de la paroi cylindrique (48) du boîtier supérieur (12), et **en ce que** la partie flexible (98) est pincée entre la paroi cylindrique (48) du boîtier supérieur (12) et la paroi cylindrique (116) du boîtier inférieur (14).

5. Dispositif optique (10) selon l'une quelconque des revendications précédentes **caractérisé en ce que** la trace conductrice (128) se prolonge jusqu'à l'extrémité libre externe (60) du support de lentille (16) pour former l'élément de chauffage (130), par exemple en formant un anneau.

6. Méthode de fabrication d'un dispositif optique (10) selon l'une quelconque des revendications précédentes, **caractérisé en ce qu'**elle comporte les étapes suivantes :
fourniture d'un support de lentille (16) monté sur une carte à circuit imprimé (26) comprenant une partie rigide (96) et une partie flexible (98) comprenant un plot de raccordement électrique (108);
agencement d'un élément de chauffage (130) sur le support de lentille (16) ;
application d'une première couche isolante (134) sur le support de lentille (16);
réalisation d'une trace électriquement conductrice (128) sur la première couche isolante s'étendant depuis l'élément de chauffage (130) jusqu'à une extrémité formant une zone de contact électrique (126) de la trace électriquement conductrice (128) ;
application d'une seconde couche isolante (138) recouvrant entièrement la trace électriquement conductrice (128) à l'exception de la zone de contact électrique (126) ;
insertion du support de lentille (16) dans un boîtier inférieur (14) de sorte à pincer un plot de raccordement électrique (108) de la partie flexible (98) entre une paroi (116) du boîtier inférieur (14) et la zone de contact électrique (126) agencée sur le support de lentille (16).

## Patentansprüche

1. Optische Vorrichtung (10), umfassend
eine Karte mit gedruckter Schaltung (26), umfassend einen elektronischen Bilderfassungskreis (30),
einen Linsenhalter (16), umfassend mindestens eine optische Linse (15), wobei der Linsenhalter (16) auf der Karte mit gedruckter Schaltung (26) derart angebracht ist, dass der elektronische Bilderfassungskreis (30) und die optische Linse (15) gemäß der optischen Achse (O) der Vorrichtung (10) ausgerichtet sind;
ein Heizelement (130), das auf dem Linsenhalter (16) eingerichtet ist;
wobei das Heizelement (130) mit der Karte mit gedruckter Schaltung (26) durch mindestens eine elektrisch leitende Spur (128), die auf dem Linsenhalter (16) eingerichtet ist, elektrisch verbunden ist, und
**dadurch gekennzeichnet, dass** der Linsenhalter (16) eine erste isolierende Schicht (134) umfasst, auf der die elektrisch leitende Spur (128) eingerichtet ist, und eine zweite isolierende Schicht (138), welche die elektrisch leitende Spur (128) bedeckt, mit Ausnahme ihrer elektrischen Kontaktzone (126).

2. Optische Vorrichtung (10) nach Anspruch 1, **dadurch gekennzeichnet, dass** die elektrisch leitende Spur (128) eine elektrische Kontaktzone (126) umfasst, die in direktem elektrischem Kontakt mit einem elektrischen Anschlussstift (108) der Karte mit gedruckter Schaltung (26) ist.

3. Optische Vorrichtung (10) nach Anspruch 2, **dadurch gekennzeichnet, dass** die Karte mit gedruckter Schaltung (26) einen flexiblen Teil (98) aufweist, auf dem der elektrische Anschlussstift (108) in Kontakt mit der elektrischen Kontaktzone (126) der elektrisch leitenden Spur (128) eingerichtet ist.

4. Optische Vorrichtung (10) nach Anspruch 3, **dadurch gekennzeichnet, dass** der Linsenhalter (16) aus einem einzigen Teil mit einem oberen Gehäuse (12) hergestellt ist, der in einem unteren Gehäuse (14) angebracht ist, wobei die elektrische Kontaktzone (126) auf der Außenseite (114) der zylindrischen Wand (48) des oberen Gehäuses (12) eingerichtet ist, und dass der flexible Teil (98) zwischen der zylindrischen Wand (48) des oberen Gehäuses (12) und der zylindrischen Wand (116) des unteren Gehäuses (14) eingeklemmt ist.

5. Optische Vorrichtung (10) nach einem der vorangehenden Ansprüche, **dadurch gekennzeichnet, dass** sich die leitende Spur (128) bis zum äußeren freien Ende (60) des Linsenhalters (16) verlängert, um das Heizelement (130) zu bilden, beispielsweise durch Bilden eines Rings.

6. Verfahren zur Herstellung einer optischen Vorrichtung (10) nach einem der vorangehenden Ansprüche, **dadurch gekennzeichnet, dass** es die folgenden Schritte umfasst:
Bereitstellen eines Linsenhalters (16), der auf einer Karte mit gedruckter Schaltung (26) angebracht ist, umfassend einen starren Teil (96) und einen flexiblen Teil (98), umfassend einen elektrischen Anschlussstift (108);
Einrichten eines Heizelements (130) auf dem Linsenhalter (16) ;
Auftragen einer ersten isolierenden Schicht (134) auf den Linsenhalter (16);
Herstellen einer elektrisch leitenden Spur (128) auf der ersten isolierenden Schicht, die sich ab dem Heizelement (130) bis zu einem Ende erstreckt, das eine elektrische Kontaktzone (126) der elektrisch leitenden Spur (128) bildet;
Auftragen einer zweiten isolierenden Schicht (138), welche die elektrisch leitende Spur (128) vollständig bedeckt, mit Ausnahme der elektrischen Kontaktzone (126);
Einsetzen des Linsenhalters (16) in ein unteres Gehäuse (14) derart, dass ein elektrischer Anschlussstift (108) des flexiblen Teils (98) zwischen einer Wand (116) des unteren Gehäuses (14) und der elektrischen Kontaktzone (126), die auf dem Linsenhalter (16) eingerichtet ist, eingeklemmt wird.

## Claims

1. An optical device (10) comprising:
a printed circuit board (26) comprising an electronic image capture circuit (30),
a lens holder (16) comprising at least one optical lens (15), the lens holder (16) being mounted on the printed circuit board (26) so as to align, along the optical axis (O) of the device (10), the electronic image capture circuit (30) and the optical lens (15);
a heating element (130) arranged on the lens holder (16);
the heating element (130) being electrically connected to the printed circuit board (26) by at least one electrically conductive trace (128) arranged on the lens holder (16) and
**characterized in that** the lens holder (16) comprises a first insulating layer (134) on which is arranged the electrically conductive trace (128) and a second insulating layer (138) covering the electrically conductive trace (128) except for its electrical contact area (126).

2. The optical device (10) according to claim 1 **characterized in that** the electrically conductive trace (128) comprises an electrical contact area (126) which is in direct electrical contact with an electrical connection pad (108) of the printed circuit board (26).

3. The optical device (10) according to claim 2 **characterized in that** the printed circuit board (26) includes a flexible portion (98) on which is arranged the electrical connection pad (108) in contact with the electrical contact area (126) of the electrically conductive trace (128).

4. The optical device (10) according to claim 3 **characterized in that** the lens holder (16) is made in one piece with an upper casing (12) mounted in a lower casing (14), the electrical contact area (126) being arranged on the outer face (114) of the cylindrical wall (48) of the upper casing (12), and **in that** the flexible portion (98) is clamped between the cylindrical wall (48) of the upper casing (12) and the cylindrical wall (116) of the lower casing (14).

5. The optical device (10) according to any one of the preceding claims **characterized in that** the conductive trace (128) extends up to the outer free end (60) of the lens holder (16) to form the heating element (130), for example by forming a ring.

6. A method for manufacturing an optical device (10) according to any one of the preceding claims, **characterized in that** it includes the following steps:
providing a lens holder (16) mounted on a printed circuit board (26) comprising a rigid portion (96) and a flexible portion (98) comprising an electrical connection pad (108);
arranging a heating element (130) on the lens holder (16) ;
applying a first insulating layer (134) on the lens holder (16);
producing an electrically conductive trace (128) on the first insulating layer extending from the heating element (130) up to one end forming an electrical contact area (126) of the electrically conductive trace (128);
applying a second insulating layer (138) completely covering the electrically conductive trace (128) except for the electric contact area (126);
inserting the lens holder (16) into a lower casing (14) so as to clamp an electrical connection pad (108) of the flexible portion (98) between a wall (116) of the lower casing (14) and the electrical contact area (126) arranged on the lens holder (16).
